# EUROPÄISCHE PATENTSCHRIFT

(11) **EP 3 948 321 B1**
(45) Veröffentlichungstag und Bekanntmachung des Hinweises auf die Patenterteilung: **31.12.2025**
(21) Anmeldenummer: 20719582.7
(22) Anmeldetag: 02.04.2020
(51) Int. Cl.: G01R 33/24

(54) **MAGNETFELDSONDE, HERSTELLUNG EINER SOLCHEN UND VERFAHREN ZUM BETRIEB EINER MAGNETFELDSONDE**
MAGNETIC FIELD PROBE, PRODUCTION OF SAME, AND METHOD FOR OPERATING A MAGNETIC FIELD PROBE
SONDE DE CHAMP MAGNÉTIQUE, FABRICATION D'UNE TELLE SONDE ET PROCÉDÉ DE FONCTIONNEMENT D'UNE SONDE DE CHAMP MAGNÉTIQUE

(30) Priorität: 05.04.2019 DE 102019109062
(43) Veröffentlichungstag der Anmeldung: 09.02.2022
(60) Teilanmeldung: 25213353.3
(73) Patentinhaber: Albert-Ludwigs-Universität Freiburg, 79098 Freiburg (DE)
(72) Erfinder: WEHKAMP, Niklas, 79104 Freiburg (DE); ZAITSEV, Maxim, 79117 Freiburg (DE); ROVEDO, Philipp, 79110 Freiburg (DE)
(74) Vertreter: Mertzlufft-Paufler, Cornelius
(86) Internationale Anmeldenummer: PCT/EP2020/059387
(87) Internationale Veröffentlichungsnummer: WO 2020/201417

(56) Entgegenhaltungen:
- EP-A1- 3 295 198
- WO-A1-2015/169655
- WO-A2-2014/027271
- JP-A- 2000 237 161
- CHRISTOPH BARMET ET AL: "A transmit/receive system for magnetic field monitoring of in vivo MRI", MAGNETIC RESONANCE IN MEDICINE, vol. 62, no. 1, 15 May 2009 (2009-05-15), pages 269 - 276, XP055052590, ISSN: 0740-3194, DOI: 10.1002/mrm.21996

## Beschreibung

Die Erfindung betrifft ein System aus einer Magnetfeldsonde und einer Ansteuerungselektronik. Die Magnetfeldsonde umfasst eine Kapsel, in der eine MR-aktive Substanz eingekapselt und eine erste Spule angeordnet ist.

Die Erfindung betrifft ferner ein System aus einer Anordnung von Magnetfeldsonden, einer Empfangselektronik und einer Ansteuerungselektronik.

Weiter betrifft die Erfindung Verfahren zur Herstellung einer Magnetfeldsonde und zum Betrieb eines Systems aus einer Magnetfeldsonde und einer Ansteuerungselektronik.

Systeme mit den eingangs beschriebenen Merkmalen, eine Herstellung von Magnetfeldsonden und Verfahren unter Verwendung einer Magnetfeldsonde sind aus der Praxis bereits bekannt.

Beispielsweise wird eine Magnetfeldsonde mit den beschriebenen Merkmalen verwendet, um ein in einem MR-Gerät erzeugtes Magnetfeld auszumessen. Hierdurch können präzise Daten über die im Rahmen einer MR-Messung tatsächlich applizierten Magnetfelder ermittelt werden, welche sodann zur Korrektur von Fehlern verwendet werden können, um hierdurch die Bildqualität eines im Wege eines MR-Verfahrens aufgenommenen Schnittbildes zu erhöhen.

Im Rahmen dieser Anmeldung werden die Abkürzung "MR" als Abkürzung für "Magnetresonanz", die Abkürzung "MRT" für "Magnetresonanztomographie", die Abkürzung "NMR" für "nuclear magnetic resonance", die Abkürzung "HF" für "Hochfrequenz" und die Abkürzung "UV" für "Ultraviolett" verwendet.

Die Magnetfeldsonde kann daher auch als MR-Sonde bezeichnet werden, wenn sie zur Verwendung in einem MR-Gerät vorgesehen ist. Sie kann auch als NMR-Sonde bezeichnet werden. Sie kann auch als MRT-Sonde bezeichnet werden, wenn sie zur Verwendung in einem MRT-Gerät vorgesehen ist. Bei dem MR-Gerät kann es sich um ein MRT-Gerät handeln oder um ein für die Spektroskopie vorgesehenes MR-Gerät oder um ein NMR-Gerät.

Ein Problem bisher bekannter Magnetfeldsonden besteht darin, dass sie für die Ausmessung des Magnetfelds in dem entsprechenden MR-Gerät jedes Mal neu aufwändig angeordnet und sodann zur Durchführung der eigentlichen MR-Messung eines Messobjekts wieder herausgenommen werden müssen. Die MR-aktive Substanz einer Magnetfeldsonde stellt nämlich einen bei der MR-Messung sichtbaren Fremdkörper dar, welcher in dem gemessenen Bild unerwünschte Artefakte hervorrufen kann. Dieses Problem wird in der Praxis bisher dadurch gelöst, dass eine besondere MR-aktive Substanz verwendet wird, deren Resonanzfrequenz von der eigentlichen Resonanzfrequenz des Messobjekts erheblich abweicht, beispielsweise indem die MR-aktive Substanz keine ¹H-Wasserstoffkerne enthält, sondern andere Kerne wie beispielsweise ¹⁹F-Kerne oder ²H-Kerne. Dies benötigt zusätzliche Breitbandelektronik und verursacht hohe Kosten.

Der wissenschaftliche Artikel von Christoph Barmet et al., A Transmit/Receive System for Magnetic Field Monitoring of In Vivo MRI, Magnetic Resonance in Medicine 62:269-276 (2009), offenbart einen Magnetresonanzsensor, bei dem eine mit einer Flüssigkeit befüllte Glaskapillare in einer ellipsoiden Epoxy-Hülle eingebettet ist, wobei um die Glaskapillare eine Hochfrequenzspule gewickelt ist.

Der Erfindung liegt die Aufgabe zugrunde, die Gebrauchseigenschaften einer Magnetfeldsonde im Zusammenhang mit dem Ausmessen eines insbesondere in einem MR-Gerät erzeugten Magnetfeldes zu verbessern.

Zur Lösung dieser Aufgabe schlägt die Erfindung die Merkmale von Anspruch 1 vor. Insbesondere wird somit erfindungsgemäß bei einem System der eingangs beschriebenen Art zur Lösung der genannten Aufgabe vorgeschlagen, dass in der Kapsel eine zweite Spule angeordnet ist, dass die zweite Spule an die Ansteuerungselektronik angeschlossen ist und dass die Ansteuerungselektronik zur Erzeugung eines zeitlich konstanten und/oder eines niederfrequenten Magnetfelds eingerichtet ist.

Die Verwendung von zwei Spulen in einer Magnetfeldsonde hat eine Vielzahl von Anwendungen, von denen eine Vielzahl von Verwendungen einer solchen erfindungsgemäßen Magnetfeldsonde eine eigene erfinderische Qualität aufweisen.

Beispielsweise kann die zweite Spule verwendet werden zur Veränderung eines Magnetfeldes in einem von der MR-aktiven Substanz gebildeten Volumen. Dies kann während einer MR-Messung eines Messobjekts und/oder während einer Anregung eines Messobjekts und/oder während einer Anregung der MR-aktiven Substanz durch Einstrahlen eines HF-Feldes und/oder während einer Signalakquisition eines von der ersten Spule empfangenen Signals und/oder während eines Zeitraums einer Relaxation einer Longitudinalmagnetisierung in der MR-aktiven Substanz erfolgen.

Beispielsweise kann die zweite Spule weiter verwendet werden zur Verschiebung der Resonanzfrequenz der MR-aktiven Substanz während einer MR-Messung. Eine Verschiebung kann durch Anlegen eines niederfrequenten Magnetfeldes mittels der zweiten Spule während einer Anregung des Messobjekts und/oder der MR-aktiven Substanz und/oder während der Aussendung eines MR-Anregungsimpulses erfolgen. Die Anregung selbst kann insbesondere durch Einstrahlen eines HF-Feldes erfolgen. Eine Verschiebung kann während einer Signalakquisition eines von der ersten Spule empfangenen Signals erfolgen. Bevorzugt wird die Resonanzfrequenz soweit verschoben, dass das Signal der MR-aktiven Substanz aus der Empfangsbandbreite und/oder der Sendebandbreite eines für die MR-Messung verwendeten MR-Geräts herausfällt. Ferner wird die Resonanzfrequenz bevorzugt soweit verschoben, dass das Signal der MR-aktiven Substanz aus der Messbandbreite eines Messsignals, welches von dem Messobjekt bei der MR-Messung erzeugt wird, und/oder aus der Sendebandbreite eines für die MR-Messung verwendeten Anregungsimpulses herausfällt. Die Verschiebung der Resonanzfrequenz kann beispielsweise erreicht werden, indem mit der zweiten Spule ein homogenes Magnetfeld in einem von der MR-aktiven Substanz gebildeten Volumen erzeugt wird. Es ist hierbei ausreichend, dass das Magnetfeld in dem von der MR-aktiven Substanz gebildeten Volumen im Wesentlichen homogen ausgebildet ist. Die Verschiebung ist dabei umso stärker, je stärker der Strom ist, von dem die zweite Spule durchflossen wird. Bevorzugt wird die zweite Spule mit einem konstanten Strom betrieben. Eine solche Resonanzverschiebung kann den Vorteil haben, dass bei einer MR-Messung eines Messobjekts interferierende Signalanteile, welche von der Magnetfeldsonde erzeugt werden, reduziert oder vermieden werden. Wird nämlich die MR-aktive Substanz wegen ihrer Resonanzverschiebung hinreichend off-resonant angeregt, so wird eine MR-Messung eines Messobjekts nicht gestört. Fällt die Resonanzfrequenz der MR-aktiven Substanz aus der Bandbreite der Empfangseinheit heraus, so wird das von der MR-aktiven Substanz ausgesendete MR-Signal nicht wirksam empfangen. Soll hingegen die Magnetfeldprobe ein Signal liefern, so wird dies bevorzugt dadurch erreicht, dass kein Strom durch die zweite Spule gesendet wird. Dies hat beispielsweise den besonderen Vorteil, dass die Magnetfeldsonde auch während der MR-Messung, durch die ein Messobjekt ausgemessen wird, in dem MR-Gerät verbleiben kann.

Die Resonanzverschiebung kann auch dann vorteilhaft sein, wenn sie innerhalb der Bandbreite der Empfangseinheit verbleibt, beispielweise wenn bei gleichzeitiger Messung des Magnetfelds und eines in dem MR-Geräts befindlichen Objekts eine Anpassung der Resonanzfrequenz der MR-aktiven Substanz vorteilhaft ist, um Signalinterferenzen mit dem von dem Objekt aufgenommen Signal zu vermeiden. Die Bandbreite der Empfangseinheit kann hierbei breiter gewählt sein als sich das aus der Bandbreite des Messobjekts ergibt. Die Resonanzverschiebung kann hierbei so gewählt sein, dass sie außerhalb der Messbandbreite des Messobjekts, jedoch innerhalb der Bandbreite der Empfangseinheit liegt.

Eine weitere Verwendung kann vorsehen, dass die zweite Spule zur Dephasierung des von der MR-aktiven Substanz erzeugten Signals verwendet wird. Dies kann beispielsweise dadurch erreicht werden, dass durch die zweite Spule ein räumlich variierendes Magnetfeld in einem von der MR-aktiven Substanz gebildeten Volumen erzeugt wird. Das Magnetfeld variiert hierbei bevorzugt linear in dem Volumen. Es genügt hierbei, wenn das Magnetfeld in dem Volumen im Wesentlichen linear variiert. Die zweite Spule wird bevorzugt mit konstantem oder niederfrequentem Strom betrieben. Eine auf diese Weise herbeigeführte Dephasierung hat beispielsweise den Vorteil, dass die Magnetfeldsonde bereits nach kurzer Zeitdauer erneut zur Ausmessung eines Magnetfeldes verwendet werden kann. Die Totzeiten können hierdurch reduziert werden bzw. an die Messung des Messobjekts angepasst werden.

Bevorzugt wird das mit der Magnetfeldsonde auszumessende Magnetfeld von einem MR-Gerät erzeugt.

Im Rahmen der hier beschriebenen Erfindung kann ein Signal als niederfrequent bezeichnet werden, wenn dessen höchster Frequenzanteil mindestens einen Faktor 10, bevorzugt mindestens einen Faktor 100, geringer ist als die Resonanzfrequenz der MR-aktiven Substanz in dem auszumessenden Magnetfeld. Insbesondere ist ein Signal bei Magnetfeldstärken zwischen 1T und 3T niederfrequent, wenn das Frequenzspektrum unterhalb von 1 MHz liegt. Ein Signal kann im Rahmen dieser Erfindung als hochfrequent bezeichnet werden, wenn es bei oder nahe bei der Resonanzfrequenz der MR-aktiven Substanz und/oder des Messobjekts liegt. Ein Anregungsimpuls, mit dem eine on- oder off-resonante Anregung der MR-aktiven Substanz und/oder eine Anregung des Messobjekts erfolgt, ist beispielsweise hochfrequent. Auch das von der MR-aktiven Substanz oder dem Messobjekt ausgestrahlte Signal ist hochfrequent.

Bei der MR-aktiven Substanz handelt es sich um einen Stoff, der Atomkerne enthält, deren Kernspins zu einer Magnetresonanz anregbar sind. Insbesondere handelt es sich hierbei um eine Substanz, die in einem MR-Gerät anregbar ist. Besonders bevorzugt handelt es sich bei einem solchen MR-Gerät um ein für die Spektroskopie und/oder Bildgebung menschlichen Gewebes vorgesehenes MR-Gerät. Die MR-aktive Substanz ist insbesondere bei Feldstärken eines homogenen Hauptmagnetfeldes zwischen 0,1 Tesla und 10 Tesla, vorzugsweise zwischen 1 Tesla und 7 Tesla anregbar. Die MR-aktive Substanz kann beispielsweise Wasserstoff in Form seines ¹H-Isotops oder eines ²H-Isotops, Kohlenstoff in Form seines ¹³C-Isotops, Fluor in Form seines ¹⁹F-Isotops, Phosphor in Form seines ³¹P-Isotops oder andere MR-aktive Isotope enthalten. Die MR-aktive Substanz kann beispielsweise Wasser sein. Dem Wasser kann mindest ein Zusatz zugefügt sein, um beispielsweise dessen magnetische Suszeptibilität und/oder Relaxationskonstanten anzupassen. Als Zusatz kann beispielsweise Kupfersulfat verwendet werden.

Die Verwendung von Wasser als MR-aktive Substanz oder die Verwendung einer MR-aktiven Substanz mit Wasserstoff hat den besonderen Vorteil, dass die Magnetfeldsonde auf einfache Weise sehr genau angesteuert und ausgelesen werden kann. Die Magnetfeldsonde kann beispielsweise angesteuert werden, indem mit der ersten Spule die MR-aktive Substanz angeregt wird und mit der zweiten Spule ein Magnetfeld erzeugt wird. Da die Ansteuerungs- und Ausleseelektronik eines MR-Geräts üblicherweise auf Wasserstoff ausgelegt ist, kann diese Elektronik zugleich verwendet werden, um die Magnetfeldsonde anzusteuern und/oder auszulesen. Die Elektronik des MR-Geräts ist üblicherweise hochpräzise. Ferner ermöglicht die Verwendung derselben Elektronik eine zeitsynchrone Steuerung und Auslesung von Magnetfeldsonde und MR-Gerät.

Die MR-aktive Substanz bildet bevorzugt ein Volumen mit einem Durchmesser von weniger als 2mm, besonders bevorzugt von weniger als 1mm. Die MR-aktive Substanz bildet bevorzugt ein Volumen von weniger als 10 Mikroliter, besonders bevorzugt von weniger als 1 Mikroliter.

Die Kapsel kann einen Körper bilden. Bevorzugt bildet die Kapsel einen homogenen Körper.

Die Kapsel ist weiter bevorzugt aus einem Material gleichmäßiger Zusammensetzung gebildet. Insbesondere kann das Material ein bestimmter Stoff oder eine gleichmäßige Mischung von zwei oder mehr Stoffen sein.

Die Tatsache, dass eine MR-aktive Substanz in der Kapsel eingekapselt ist, kann dahingehend zu verstehen sein, dass die MR-aktive Substanz vollständig von einem die Kapsel bildenden Material umgeben ist. Die MR-aktive Substanz hat daher keinen direkten Kontakt zu einem Bereich außerhalb der Kapsel.

Eine Spule kann dahingehend charakterisiert sein, dass sie einen Abschnitt eines elektrischen Leiters bildet. Der Leiter ist bevorzugt ein isolierter Leiter. Wird die Spule von einem elektrischen Strom durchflossen, wird ein Magnetfeld erzeugt.

Die erste Spule und/oder die zweite Spule können hierbei in der Kapsel eingekapselt sein. Ein Strom könnte in diesem Fall beispielsweise durch drahtlose Energieübertragung in der ersten Spule und/oder der zweiten Spule erzeugt werden.

Bevorzugt ist allerdings vorgesehen, dass elektrische Anschlüsse der ersten Spule und/oder der zweiten Spule aus der Kapsel herausgeführt werden. Die Anschlüsse erlauben eine präzise und energieeffiziente Signal- und Energieübertragung.

Bevorzugt ist die MR-aktive Substanz in die Kapsel eingebracht.

Weiter bevorzugt ist die MR-aktive Substanz mittig in der Kapsel angeordnet.

Weiter bevorzugt sind die erste Spule und die zweite Spule aus einem gleichen Material gefertigt. Beispielsweise sind die beiden Spulen aus Kupfer gefertigt.

Bei einer vorteilhaften Ausgestaltung der Magnetfeldsonde kann vorgesehen sein, dass eine dritte Spule oder weitere Spulen in der Magnetfeldsonde angeordnet ist oder sind. Die dritte Spule oder die weiteren Spulen können hierbei Merkmale aufweisen wie sie in Bezug auf die erste oder die zweite Spule beschrieben sind. Durch derartige Ausgestaltungen kann die Magnetfeldsonde noch vielseitiger eingesetzt werden.

Bei einer vorteilhaften Ausgestaltung der Magnetfeldsonde kann vorgesehen sein, dass die Kapsel kugelförmig ausgebildet ist. Die Kapsel kann auch anders ausgebildet sein, beispielsweise als Ellipsoid oder zylinderförmig. Eine kugelförmige Ausbildung der Kapsel hat allerdings den besonderen Vorteil, dass die Feldlinien in dem Objekt homogen verlaufen, sodass die Messeigenschaften der Magnetfeldsonde verbessert werden und diese präzisere Daten liefert.

Zur Verbesserung der mit der Magnetfeldsonde erreichbaren Messqualität kann weiter vorgesehen sein, dass die Materialien der Kapsel, der ersten Spule, der zweiten Spule und/oder der MR-aktiven Substanz aufeinander abgestimmt sind. Beispielsweise kann vorgesehen sein, dass die Kapsel aus einem Material gebildet ist, dessen magnetische Suszeptibilität auf die Suszeptibilität eines Materials der ersten Spule und/oder eines Materials der zweiten Spule abgestimmt ist. Alternativ oder zusätzlich kann vorgesehen sein, dass die Suszeptibilität der MR-aktiven Substanz auf die Suszeptibilität eines Materials der ersten Spule und/oder eines Materials der Kapsel abgestimmt ist. Die Suszeptibilitäten sind insbesondere dann aufeinander abgestimmt, wenn sie gleich oder zumindest im Wesentlichen gleich sind. Leichte Abweichungen führen nur zu geringen Signalstörungen, sodass geringe Abweichungen, durch die die Signalqualität der Magnetfeldsonde nicht erheblich verschlechtert wird, tolerabel sein können. Suszeptibilitätsunterschiede führen nämlich dazu, dass die entstehenden Feldinhomogenitäten das von der MR-aktiven Substanz generierte MR-Signal stören und daher die Messqualität verschlechtern.

Eine Abstimmung der Suszeptibilitäten kann beispielsweise dadurch erfolgen, dass das Spulenmaterial in geeigneter Weise gewählt wird. Beispielsweise kann Kupfer verwendet werden oder eine Legierung mit einer gewünschten Suszeptibilität. Die Suszeptibilität des Materials der Kapsel kann durch entsprechende Wahl des Materials angepasst werden oder durch Zugabe bestimmter Stoffe zu dem Material, welche die Suszeptibilität verändern. Auch die Suszeptibilität der MR-aktiven Substanz kann durch die Wahl der Substanz beeinflusst werden, aber auch indem der Substanz bestimmte Zusätze hinzugegeben werden, indem sie beispielsweise mit einem die Suszeptibilität beeinflussenden Dotiermittel dotiert wird.

Bei einer weiteren vorteilhaften Ausgestaltung der Magnetfeldsonde kann vorgesehen sein, dass die MR-aktive Substanz einen in und/oder von der Kapsel gebildeten Hohlraum ausfüllt. Ein Hohlraum kann dadurch charakterisiert sein, dass er nach außen abgeschlossen ist.

Bei einer weiteren vorteilhaften Ausgestaltung der Magnetfeldsonde kann vorgesehen sein, dass die MR-aktive Substanz die Kapsel, welche vorzugsweise aus einem Material gleichmäßiger Zusammensetzung besteht, unmittelbar kontaktiert. Dann kontaktiert die MR-aktive Substanz auch das Material der Kapsel unmittelbar. Bevorzugt kontaktiert die MR-aktive Substanz die Kapsel, und somit das Material der Kapsel, mit der gesamten Oberfläche der MR-aktiven Substanz.

Zur Vermeidung von Suszeptibilitätssprüngen ist es vorteilhaft, wenn in der Kapsel und/oder in der MR-aktiven Substanz keine Lufteinschlüsse vorhanden sind.

Bei einer weiteren vorteilhaften Ausgestaltung der Magnetfeldsonde kann vorgesehen sein, dass die MR-aktive Substanz in einem von einer Wicklung der ersten Spule umgebenen Volumen angeordnet ist. Alternativ oder zusätzlich kann vorgesehen sein, dass die MR-aktive Substanz in einem von einer Wicklung der zweiten Spule umgebenen Volumen angeordnet ist. Ein Signal, welches von der MR-aktiven Substanz erzeugt wird, steht dann in besonders effizienter Wechselwirkung mit den Spulen.

Bei einer weiteren vorteilhaften Ausgestaltung der Erfindung kann vorgesehen sein, dass eine Wicklung der ersten Spule innerhalb einer Wicklung der zweiten Spule angeordnet ist. Bevorzugt sind dabei die Wicklungen der ersten Spule und der zweiten Spule und/oder die von den beiden Spulen erzeugten Magnetfelder orthogonal zueinander orientiert. Derartige Anordnungen ermöglichen besonders kompakte Spulenwicklungen und besonders kompakte Magnetfeldsonden.

Bevorzugt füllt die MR-aktive Substanz eines oder beide der zuvor genannten Volumina aus. Hierdurch kann die Stärke des erzeugten MR-Signals erhöht werden, wodurch die Messqualität verbessert werden kann.

Weiter kann vorgesehen sein, dass die erste Spule und/oder die zweite Spule eine zylinderförmige Wicklung aufweist. Diese Spulen können insbesondere mit hohem Wirkungsgrad zur Generierung eines homogenen oder linear variierenden oder in anderer Weise räumlich variierenden Magnetfeldes verwendet werden. Ferner können sie auf besonders einfache Weise hergestellt werden. Andere Spulengeometrien sind allerdings auch möglich, wie beispielsweise flach ausgebildete Spulen.

Bei einer weiteren vorteilhaften Ausgestaltung der erfindungsgemäßen Magnetfeldsonde kann vorgesehen sein, dass die zweite Spule derart ausgebildet ist, dass mit ihr in einem von der MR-aktiven Substanz gebildeten Volumen ein homogenes Magnetfeld erzeugbar ist. Es ist hierbei ausreichend, wenn das Magnetfeld im Wesentlichen homogen ist. Dies erlaubt interessante Anwendungen. Einige dieser Anwendungen sind weiter oben beschrieben. Ein homogenes Magnetfeld kann beispielsweise von einer Solenoid-Spule erzeugt werden oder von einer Helmholtz-Spule oder auch mit einer Spule einer anderen Geometrie, wobei zum Auffinden einer geeigneten Wicklung beispielsweise auch Computersimulationen oder Optimierungsverfahren eingesetzt werden können.

Bei einer weiteren vorteilhaften Ausgestaltung der Magnetfeldsonde kann vorgesehen sein, dass die zweite Spule derart ausgebildet ist, dass mit ihr in einem von der MR-aktiven Substanz gebildeten Volumen ein räumlich variierendes Magnetfeld erzeugbar ist. Die zweite Spule ist hierbei bevorzugt derart ausgebildet, dass mit ihr in einem von der MR-aktiven Substanz gebildeten Volumen ein linear variierendes Magnetfeld erzeugbar ist. Es genügt hierbei, dass Magnetfeld in dem Volumen im Wesentlichen linear variiert. Möglich und vorteilhaft können auch Ausgestaltungen sein, bei denen das Magnetfeld räumlich auf nicht-lineare Weise variiert. Derartige Variationen können interessante Anwendungen haben, von denen einige bereits zuvor beschrieben worden sind. Eine Spule, welche ein räumlich variierendes Feld erzeugt, kann beispielsweise eine Maxwell-Spule sein oder eine beliebige andere Spule, welche ein derartiges variierendes Magnetfeld erzeugt.

Die Verwendung eines Helmholtz-Spulenpaares kann besonders vorteilhaft sein, da durch sie einerseits ein homogenes Magnetfeld erzeugt werden kann, indem die beiden Spulen im gleichen Sinn bestromt werden, aber auch ein variierendes, vorzugsweise linear variierendes, Feld, indem die Spulen gegensinnig bestromt werden. Derartige Magnetfeldsonden sind daher vielfältig einsetzbar. Um zu erreichen, dass das Helmholtz-Spulenpaar gleichsinnig und gegensinnig betreibbar sind, kann es vorteilhaft sein, wenn das Spulenpaar nicht aus einer einzelnen Spule gebildet ist, sondern aus zwei Spulen, welche jeweils separate Anschlüsse haben. In diesem Fall weist die Magnetfeldsonde zumindest drei Spulen auf.

Weiter kann vorgesehen sein, dass die Kapsel aus einem ausgehärteten Material gebildet ist. Das Material kann beispielsweise durch elektromagnetische Strahlung wie etwa Licht oder UV-Licht ausgehärtet worden sein. Die Kapsel kann beispielsweise aus einem ausgehärteten Klebstoff und/oder aus einem Polymer bestehen. Das Material kann auch ein Thermoplast sein, welcher durch Erkalten ausgehärtet worden ist. Zweckmäßig kann auch ein Material sein, das durch Erwärmung ausgehärtet worden ist.

Bei einer weiteren vorteilhaften Ausgestaltung kann vorgesehen sein, dass die MR-aktive Substanz einen von der Kapsel gebildeten Hohlraum ausfüllt. Die Kapsel besteht dabei vorzugsweise aus einem Material gleichmäßiger Zusammensetzung. Bevorzugt ist vorgesehen, dass die MR-aktive Substanz die Kapsel unmittelbar kontaktiert. Besonders bevorzugt kontaktiert die MR-aktive Substanz die Kapsel mit der gesamten Oberfläche der MR-aktiven Substanz. Die MR-aktive Substanz kann beispielsweise jedoch auch mit einem ersten Teil ihrer Oberfläche die Kapsel und mit einem anderen Teil, insbesondere dem übrigen Teil, ihrer Oberfläche die erste und/oder die zweite Spule kontaktieren. Weitere Varianten ergeben sich durch Kombination mit Merkmalen von Varianten und Ausgestaltungen der bereits zuvor beschriebenen Magnetfeldsonde. Insbesondere kann die Magnetfeldsonde eine zweite Spule aufweisen.

Zur Lösung der genannten Aufgabe sind erfindungsgemäß die Merkmale des auf ein System aus einer Anordnung von Magnetfeldsonden, einer Empfangselektronik und einer Ansteuerungselektronik gerichteten nebengeordneten Anspruchs vorgesehen. Insbesondere ist zur Lösung der genannten Aufgabe vorgesehen, dass die Magnetfeldsonden jeweils wie zuvor beschrieben ausgebildet sind. Durch die Verwendung einer Mehrzahl von Magnetfeldsonden kann ein Magnetfeld genauer ausgemessen werden. Beispielsweise können 16 Magnetfeldsonden verwendet werden, wodurch das Magnetfeld in seiner Multipolentwicklung bis zum Grad 3 approximiert werden kann. Je nach Anwendung kann die Anordnung auch weniger oder mehr Magnetfeldsonden aufweisen.

Erfindungsgemäss ist bei der Ausgestaltung der Anordnung von Magnetfeldsonden vorgesehen, dass die erste Spule an eine Empfangselektronik angeschlossen ist, wobei die Empfangselektronik zum Empfang eines von der MR-aktiven Substanz ausgesendeten Signals eingerichtet ist. Zusätzlich ist vorgesehen, dass die zweite Spule an eine Ansteuerungselektronik, insbesondere Sendeelektronik, angeschlossen ist, wobei die Ansteuerungselektronik zur Erzeugung eines zeitlich konstanten und/oder eines niederfrequenten Magnetfelds eingerichtet ist. Eine derartige Anordnung von Magnetfeldsonden ist flexibel einsetzbar. Bei der Empfangselektronik und/oder der Ansteuerungselektronik handelt es sich bevorzugt um die Empfangselektronik und/oder die Ansteuerungselektronik eines MR-Geräts, welches das mit der Magnetfeldsonde auszumessende Magnetfeld generiert.

Zur Lösung der genannten Aufgabe sind erfindungsgemäß die Merkmale des auf ein Herstellungsverfahren zur Herstellung einer Magnetfeldsonde gerichteten Anspruchs vorgesehen. Insbesondere wird zur Lösung der genannten Aufgabe somit erfindungsgemäß bei einem solchen Herstellungsverfahren vorgeschlagen, dass eine erste Spule in einem aushärtbaren Material angeordnet wird und dass sodann das aushärtbare Material ausgehärtet wird. Ferner ist erfindungsgemäß vorgesehen, dass vor der Aushärtung des Materials eine MR-aktive Substanz in das Material eingebracht wird. Hierdurch wird die MR-aktive Substanz insbesondere in und von dem aushärtbaren Material eingekapselt. Die MR-aktive Substanz wird bevorzugt direkt oder unmittelbar in das Material eingebracht. Weiter bevorzugt wird die MR-aktive Substanz in das Material injiziert. Die Injizierung kann beispielsweise mittels einer Pipette oder mittels eines Mikrofluiddruckers erfolgen. Bevorzugt ist vorgesehen, dass das Einbringen, insbesondere die Injizierung, der MR-aktiven Substanz durch Verdrängung des Materials erfolgt. Das Einbringen der MR-aktiven Substanz unmittelbar in das aushärtbare Material, welches nach Aushärtung die bereits zuvor genannte Kapsel bildet, hat den Vorteil, dass die Herstellung der Magnetfeldsonde besonders einfach wird, da beispielsweise auf die Verwendung von Glasröhrchen verzichtet werden kann, in denen die MR-aktive Substanz eingebracht würde.

Außerdem lässt ein derartiges Herstellungsverfahren große Freiheiten für die Spulenkonstruktion und das Design der Kapsel.

Erfindungsgemäß ist bei dem Herstellungsverfahren vorgesehen, dass vor der Aushärtung des Materials eine zweite Spule in dem Material angeordnet wird. Hierdurch kann eine Magnetfeldsonde mit Merkmalen wie zuvor beschrieben auf besonders einfache Weise hergestellt werden.

Zusätzlich kann bei dem Herstellungsverfahren vorgesehen sein, dass in ein Innenvolumen, welches von einer außenliegenden Oberfläche eines aushärtbaren Materials umschlossen ist, eine MR-aktive Substanz eingebracht, insbesondere injiziert, wird und das Material sodann ausgehärtet wird, wobei vor der Aushärtung des Materials eine erste Spule in dem Innenvolumen angeordnet wird. Das Herstellungsverfahren ermöglicht somit die Herstellung einer Magnetfeldsonde, die insbesondere wie zuvor beschrieben ausgebildet sein kann. Bevorzugt wird hierbei die MR-aktive Substanz durch Einbringen, insbesondere Injizierung, in das Material eingebracht.

Die zuvor beschriebenen Herstellungsverfahren können auch miteinander kombiniert werden. Varianten der Herstellungsverfahren ergeben sich durch Veränderung der Reihenfolge der einzelnen zur Herstellung der Magnetfeldsonde erforderlichen Herstellungsschritte. Bevorzugt ist vorgesehen, dass zunächst die erste und/oder die zweite Spule positioniert werden und in einem nächsten Schritt das aushärtbare Material an die bereits positionierten Spulen gebracht wird, bevor sodann die MR-aktive Substanz in das Innenvolumen eingebracht und/oder in das Material injiziert wird. Alternativ kann beispielsweise auch zunächst das aushärtbare Material hergerichtet werden, sodann die erste und/oder zweite Spule in dem Material positioniert werden und in einem dritten Schritt die MR-aktive Substanz hinzugefügt werden.

Bevorzugt wird die MR-aktive Substanz wie bereits zuvor beschrieben in einem von einer Wicklung der ersten Spule umgebenen Volumen und/oder in einem von einer Wicklung der zweiten Spule umgebenen Volumen angeordnet.

Weiter bevorzugt wird, wie bereits zuvor beschrieben, eine Wicklung der ersten Spule innerhalb einer Wicklung der zweiten Spule angeordnet, wobei die Wicklungen der ersten Spule und der zweiten Spule und/oder die von den beiden Spulen erzeugten Magnetfelder vorzugsweise orthogonal zueinander orientiert sind.

Bevorzugt bildet das aushärtbare Material und/oder das zuvor beschriebene Innenvolumen und/oder die MR-aktive Substanz einen Tropfen.

Bei einer vorteilhaften Ausgestaltung der Herstellungsverfahren kann vorgesehen sein, dass das Material mittels elektromagnetischer Strahlung wie etwa Licht, Ultraviolett-Licht, Röntgenstrahlung oder Infrarotstrahlung und/oder durch Temperaturvariation wie insbesondere durch Erwärmung und/oder Erkalten und/oder katalytisch wie beispielsweise durch Verwendung eines Zweikomponentenepoxidharzes ausgehärtet wird. Das Material kann daher insbesondere ein vorzugsweise mittels UV-Licht härtender Klebstoff und/oder ein lichthärtendes Polymer und/oder ein Thermoplast sein. Die bereits zuvor beschriebene Kapsel kann daher aus einem ausgehärteten Material gebildet sein, wobei dieses Material ein Thermoplast ist und/oder ein mittels elektromagnetischer Strahlung ausgehärtetes Material. Die Verwendung derartiger Materialien und Aushärteverfahren kann die Herstellung der Magnetfeldsonden und die Eigenschaften der hergestellten Magnetfeldsonden vereinfachen und verbessern.

Bevorzugt ist oder wird die erste und/oder die zweite Spule so angeordnet, dass ihre elektrischen Anschlüsse jeweils nach außen aus dem Innenvolumen und/oder aus dem aushärtbaren Material herausragen.

Bei der weiteren vorteilhaften Ausgestaltung der Herstellungsverfahren kann vorgesehen sein, dass zunächst ein Quantum des aushärtbaren Materials auf einer Arbeitsfläche hergerichtet und sodann ausgehärtet wird. Bei der Arbeitsfläche handelt es sich vorzugsweise um eine ebene Arbeitsfläche. Die Herrichtung kann beispielsweise dadurch erfolgen, dass ein Tropfen des aushärtbaren Materials auf die Arbeitsfläche gegeben wird. Nach der Aushärtung des Materials wird sodann das ausgehärtete Quantum umgedreht, insbesondere senkrecht zu seiner Symmetrieachse um 180°, und dient sodann als Unterlage für die weitere Herstellung der Magnetfeldsonde unter Anwendung der Herstellungsschritte, wie zuvor beschrieben. Derartige Ausgestaltungen der Herstellungsverfahren haben den Vorteil, dass hierdurch die Positionierung der ersten und/oder der zweiten Spule sowie der MR-aktiven Substanz in der Kapsel an einer gewünschten Position vereinfacht wird.

Bei einer weiteren vorteilhaften Ausgestaltung der Herstellungsverfahren kann vorgesehen sein, dass die Kapsel der Magnetfeldsonde durch mehrfaches Auftragen einer jeweils neuen Schicht noch nicht ausgehärten Materials und Aushärten der zuletzt aufgetragenen Schicht hergestellt wird. Hierdurch kann die Form der Kapsel kontrolliert hergestellt werden, so dass diese eine gewünschte Form wie beispielsweise eine Kugelform erhält.

Bei einer weiteren vorteilhaften Ausgestaltung der Herstellungsverfahren kann vorgesehen sein, dass das aushärtbare Material viskoser ist als die MR-aktive Substanz. Dies hat den Vorteil, dass die MR-aktive Substanz leichter in das Material eingebracht werden kann.

Alternativ kann vorgesehen sein, dass das aushärtbare Material weniger viskos ist als die MR-aktive Substanz. Dies hat den Vorteil, dass Lufteinschlüsse unterbunden werden.

Zur Anpassung der Viskosität der MR-aktiven Substanz kann diese insbesondere mindestens einen Zusatz enthalten, welcher die Viskosität beeinflusst. Beispielsweise kann die MR-aktive Substanz einen gelierenden Zusatz wie etwa Agarose enthalten. Die MR-aktive Substanz kann insbesondere Wasser und einen solchen Zusatz sowie ggf. weitere Zusätze enthalten oder hieraus bestehen.

Bei einer weiteren vorteilhaften Ausgestaltung der Erfindung kann vorgesehen sein, dass die Materialeigenschaften der MR-aktiven Substanz und des aushärtbaren Materials so gewählt werden, dass die MR-aktive Substanz nach dem Einbringen in das Material eine elliptische, vorzugsweise kugelförmige Geometrie annimmt. Eine elliptische, und erst recht eine kugelförmige Geometrie, ist erstens besonders kompakt und zweitens liefert das von einer derartigen Geometrie ausgehende Signal besonders genaue Informationen über eine Eigenschaft des auszumessenden Magnetfelds.

Bevorzugt werden Oberflächenspannung, Viskosität und Dichte der MR-aktiven Substanz und des aushärtbaren Materials so gewählt, dass die MR-aktive Substanz nach dem Einbringen in das Material eine elliptische, vorzugsweise kugelförmige Geometrie annimmt.

Besonders bevorzugt führt die Wahl der Oberflächenspannungen zu einer Phasenseparation, die selbst mechanischen Einflüssen standhält. Dann kann die MR-aktive Substanz beispielsweise leichter positioniert werden.

Die richtige Viskosität ist unter anderem besonders wichtig, damit es bei dem Einbringen der MR-aktiven Substanz in das aushärtbare Material zu einem Tropfenabriss kommen kann und die MR-aktive Substanz im Material bleibt, bevor die Kapsel ausgehärtet wird.

Dies kann eine Obergrenze der Viskosität bedingen. Andererseits kann eine hohe Viskosität vorteilhaft sein, da die Beweglichkeit der MR-aktiven Substanz so schon vor der Aushärtung des Materials eingeschränkt wird und die MR-aktive Substanz leichter positioniert werden kann. Die Dichte des Materials darf nicht zu stark von der Dichte der MR-aktiven Substanz abweichen, da ansonsten die MR-aktive Substanz auftreiben oder absinken kann.

Zur Lösung der genannten Aufgabe kann weiter ein nicht eigenständig beanspruchtes Messverfahren zum Messen einer Eigenschaft eines Magnetfeldes vorgesehen sein. Bei der zu messenden Eigenschaft kann es sich insbesondere um eine Magnetfeldstärke und/oder dessen zeitliche Entwicklung an der Position der Magnetfeldsonde. Insbesondere wird zur Lösung der genannten Aufgabe bei einem solchen Messverfahren vorgeschlagen, dass eine Magnetfeldsonde, welche wie zuvor beschrieben ausgebildet ist, verwendet wird. Bevorzugt wird das Magnetfeld von einem MR-Gerät erzeugt. Weiter bevorzugt wird vor, nach oder während der Messung der Eigenschaft des Magnetfeldes mit dem MR-Gerät eine MR-Messung eines Messobjekts durchgeführt, wobei die Magnetfeldsonde hierbei in dem MR-Gerät verbleibt.

Zur Lösung der genannten Aufgabe sind erfindungsgemäß die Merkmale des auf ein Verfahren zum Betrieb eines Systems aus einer Magnetfeldsonde und einer Ansteuerungselektronik gerichteten Anspruchs vorgesehen. Insbesondere ist zur Lösung der genannten Aufgabe somit erfindungsgemäß vorgesehen, dass das System erfindungsgemäß, insbesondere wie zuvor beschrieben und/oder gemäß eine der auf ein System gerichteten Ansprüche, ausgebildet ist. Bevorzugt wird mittels der ersten Spule ein Signal der MR-aktiven Substanz empfangen und mittels der zweiten Spule ein zeitlich konstantes Magnetfeld erzeugt. Alternativ oder zusätzlich wird mittels der zweiten Spule ein niederfrequentes Magnetfeld erzeugt. Weiter wird alternativ oder zusätzlich mittels der zweiten Spule ein hochfrequentes Magnetfeld erzeugt. Interessante Weiterbildungen und Anwendungen derartiger Verfahren sind bereits zuvor beschrieben worden.

Besonders bevorzugt wird das mittels der ersten Spule empfangene Signal mittels einer Empfangselektronik eines MR-Geräts weiterverarbeitet. Weiter bevorzugt wird die zweite Spule mittels einer Ansteuerungselektronik eines MR-Geräts angesteuert. Die Magnetfeldsonde ist hierbei bevorzugt in dem MR-Gerät angeordnet.

Weitere Ausgestaltungen eines Verfahrens zum Betrieb einer Magnetfeldsonde sind bereits weiter oben im Zusammenhang mit bestimmten Verwendungen der Magnetfeldsonde beschrieben worden. Die dort beschriebenen Verfahren sind auch unabhängig von den konkret beschriebenen Verwendungen Gegenstand erfindungsgemäßer Weiterbildungen des zuvor beschriebenen Verfahrens.

Bei einer weiteren vorteilhaften Ausgestaltung des Verfahrens kann vorgesehen sein, dass die MR-aktive Substanz eine Resonanzverschiebung gegenüber der Resonanzfrequenz einer Substanz eines in einem MR-Gerät angeordneten Messobjekts aufweist. Bei der Substanz handelt es sich insbesondere um Wasser. Die Resonanzverschiebung kann durch geeignete Herrichtung der MR-aktiven Substanz erfolgen, beispielsweise durch Wahl eines geeigneten Moleküls für die MR-aktive Substanz und/oder durch Dotierung mit einem Zusatzstoff. Alternativ oder zusätzlich kann die zweite Spule ausgebildet sein, ein homogenes Magnetfeld zu erzeugen, und mit einem konstanten Strom betrieben werden, um die Resonanzverschiebung zu erzielen, insbesondere wie bereits zuvor beschrieben. Die verschobene Resonanzfrequenz liegt hierbei bevorzugt außerhalb der Bandbreite, die für die Messung des Messobjekts verwendet wird. Alternativ kann die zweite Spule mit einem niederfrequenten Wechselstrom betrieben werden. Hierdurch kann sich die Resonanzfrequenz der MR-aktiven Substanz in mehrere Frequenzen aufspalten, was ein störungsfreies gleichzeitiges Anregen der MR-aktiven Substanz und Auslesen eines von der MR-aktiven Substanz erzeugten Signals erlaubt. Zur Anregung des Messobjekts und/oder der MR-aktiven Substanz kann eine HF-Sendespule des MR-Geräts verwendet werden. Zur Anregung der MR-aktiven Substanz kann alternativ die erste Spule verwendet werden. Möglich ist auch, hierfür eine dritte in der Magnetfeldsonde angeordnete Spule zu verwenden. Auf diese Weise wird ermöglicht, mittels der Magnetfeldsonde einer Eigenschaft eines Magnetfeldes zu messen, während zeitgleich eine MR-Messung eines Messobjekts durchgeführt wird, ohne dass das von der MR-aktiven Substanz erzeugte Signal mit dem von dem Messobjekt erzeugten Signal beim Signalempfang interferieren würde.

Die Erfindung wird nun anhand einiger weniger Ausführungsbeispiele näher beschrieben, ist jedoch nicht auf diese wenigen Ausführungsbeispiele beschränkt. Weitere Erfindungsvarianten und Ausführungsbeispiele ergeben sich durch Kombination der Merkmale einzelner oder mehrerer Schutzansprüche untereinander und/oder mit einzelnen oder mehreren Merkmalen der Ausführungsbeispiele und/oder der zuvor beschriebenen Varianten erfindungsgemäßer Vorrichtungen und Verfahren.

Es zeigt:
- Fig. 1: ein Ausführungsbeispiel einer erfindungsgemäßen Magnetfeldsonde,
- Fig. 2: ein Ausführungsbeispiel eines erfindungsgemäßen Herstellungsverfahrens zur Herstellung einer Magnetfeldsonde gemäß Figur 1,
- Fig. 3: ein alternatives Ausführungsbeispiel eines erfindungsgemäßen Herstellungsverfahrens zur Herstellung einer Magnetfeldsonde gemäß Figur 1.

Bei der nachfolgenden Beschreibung verschiedener Ausführungsbeispiele der Erfindung erhalten in ihrer Funktion übereinstimmende Elemente auch bei abweichender Gestaltung oder Formgebung übereinstimmende Bezugszahlen.

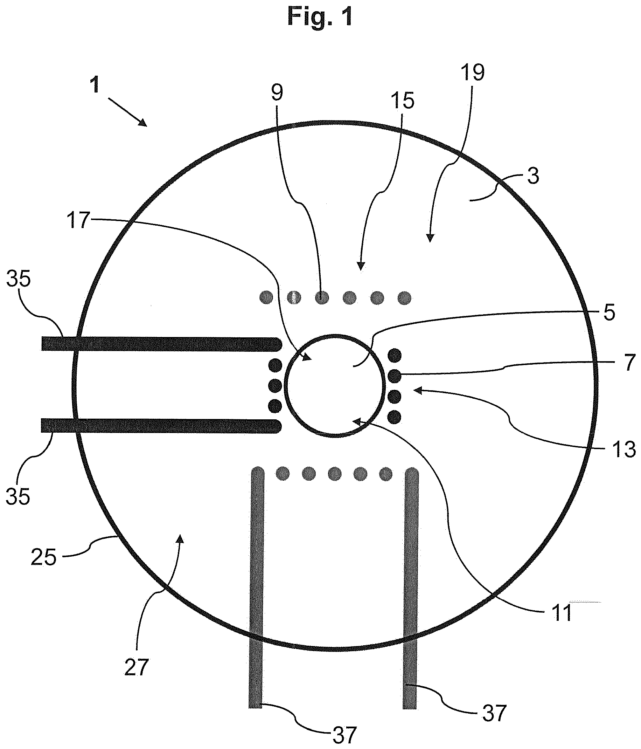

Die in Figur 1 gezeigte Magnetfeldsonde 1 weist eine Kapsel 3 aus durch Ultraviolett-Licht ausgehärtetem Material 19 auf. Die Kapsel 3 ist kugelförmig ausgebildet. Die Kapsel 3 ist massiv ausgebildet und nach außen abgeschlossen. Die Oberfläche 25 bildet eine geschlossene Fläche, lediglich an vier Punkten ragen Anschlüsse 35 und 37 für eine in der Kapsel 3 eingebettete erste Spule 7 und zweite Spule 9 aus der Kapsel 3 heraus. In der Mitte der Kapsel 3 ist ein Hohlraum 11 ausgebildet, der vollständig gefüllt ist mit einer MR-aktiven Substanz 5, welche im hier beschrieben Ausführungsbeispiel im Wesentlichen aus Wasser besteht, welches dotiert ist mit einem Stoff, der dazu führt, dass die Suszeptibilität der MR-aktiven Substanz 5 der Suszeptibilität des Materials 19 der Kapsel 3 und der Suszeptibilität der aus Kupferdraht bestehenden ersten Spule 7 und zweiten Spule 9 gleich sind.

Die erste Spule 7 weist eine Wicklung 13 auf. Die Wicklung 13 ist so ausgestaltet, dass die Spule 7 eine Solenoid-Spule bildet. Auch die zweite Spule 9 weist eine Wicklung 15 auf. Die Spule 9 bildet in dem hier beschriebenen Ausführungsbeispiel ebenfalls eine Solenoid-Spule. Die erste Spule 7 hat einen Innendurchmesser, der dem Außendurchmesser des von der MR-aktiven Substanz einnehmenden Volumens 17 entspricht. Die erste Spule 7 ist in einem von der zweiten Spule 9 umschlossenen Volumen angeordnet. Die erste Spule 7 und die zweite Spule 9 sind orthogonal zueinander orientiert.

Die MR-aktive Substanz 5 ist in der Kapsel 3 eingekapselt. Die MR-aktive Substanz 5 ist in der Kapsel 3 eingeschlossen.

Die MR-aktive Substanz 5 ist in einem Innenvolumen 27 angeordnet, wobei das Innenvolumen 27 in dem hier beschriebenen Ausführungsbeispiel dasjenige Volumen einnimmt, welches von der außenliegenden Oberfläche 25 des ausgehärteten Materials 19 umschlossen ist.

Die solenoidförmige zweite Spule 9 erzeugt in dem von der MR-aktiven Substanz 5 gebildeten Volumen 17 ein homogenes Magnetfeld, wenn eine Potentialdifferenz an den Anschlüssen 37 der zweiten Spule 9 anliegt und daher ein Strom durch die zweite Spule 9 fließt.

Wird die zweite Spule 9 mit konstantem Strom betrieben, ändert sich somit die Magnetfeldstärke gleichmäßig in dem Volumen 27 der MR-aktiven Substanz 5, sodass die Resonanzfrequenz der Kernspins der in der MR-aktiven Substanz 5 enthaltenen Wasserstoffkerne um einen von Stromstärke abhängigen Wert verschoben werden. Einige technische Wirkungen und praktische Anwendungen sind diesbezüglich bereits oben beschrieben worden.

In alternativen Ausführungsbeispielen, die hier nicht gezeigt sind, sind die erste Spule 7 und/oder die zweite Spule 9 anders ausgestaltet, sodass beispielsweise von der zweiten Spule 9 kein homogenes Magnetfeld erzeugt wird, sondern ein räumliches variierendes Magnetfeld wie etwa ein linear variierendes Magnetfeld. Einige Varianten sind insoweit bereits weiter oben beschrieben worden.

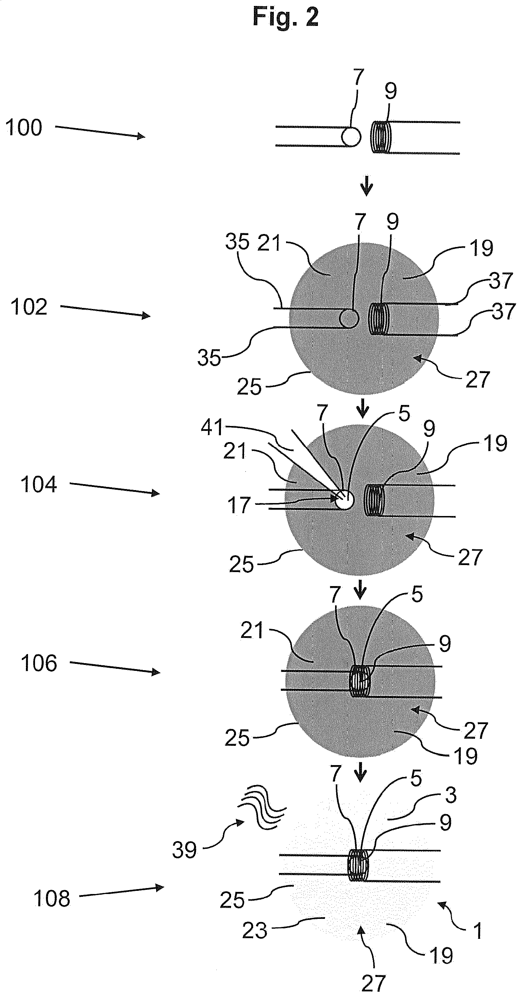

Figur 2 zeigt von oben nach unten mehrere Schritte eines Verfahrens, mit dem eine Magnetfeldsonde 1 gemäß Figur 1 hergestellt werden kann. In einem ersten Verfahrensschritt 100 werden die erste Spule 7 und die zweite Spule 9 nebeneinander positioniert. In einem zweiten Verfahrensschritt 102 wird sodann ein Tropfen aushärtbaren Materials 19, welches nach Aushärtung die Kapsel 3 der Magnetfeldsonde 1 bildet, aufgetragen, sodass die erste Spule 7 und die zweite Spule 9 in der Mitte des Materials 19 angeordnet sind. Die Anschlüsse 35 und 37 der ersten Spule 7 und der zweiten Spule 9 ragen aus dem Material 19 heraus.

In einem dritten Verfahrensschritt 104 wird sodann mittels einer Pipette 41 ein kleiner Tropfen der MR-aktiven Substanz 5 in das aushärtbare Material 19 injiziert. Dies erfolgt in ein von der ersten Spule 7 umschlossenes Volumen. Durch das Einbringen der MR-aktiven Substanz 5 in das Material 19 wird an dieser Stelle das Material 19 verdrängt. Die MR-aktive Substanz 5 bildet eine kugelförmige Geometrie aus, deren kugelförmige Oberfläche vollständig in und von dem Material 19 eingekapselt ist. Im hier gezeigten Ausführungsbeispiel entspricht der Durchmesser des von der MR-aktiven Substanz 5 eingenommenen Volumens 17 dem Innendurchmesser der ersten Spule 7. Der Innendurchmesser der ersten Spule 7 kann beispielsweise 1mm und deren Außendurchmesser kann beispielsweise 1,4mm betragen. In einem alternativen Ausführungsbeispiel ist der Innendurchmesser der ersten Spule 7 größer als der Durchmesser des von der MR-aktiven Substanz 5 eingenommenen Volumens.

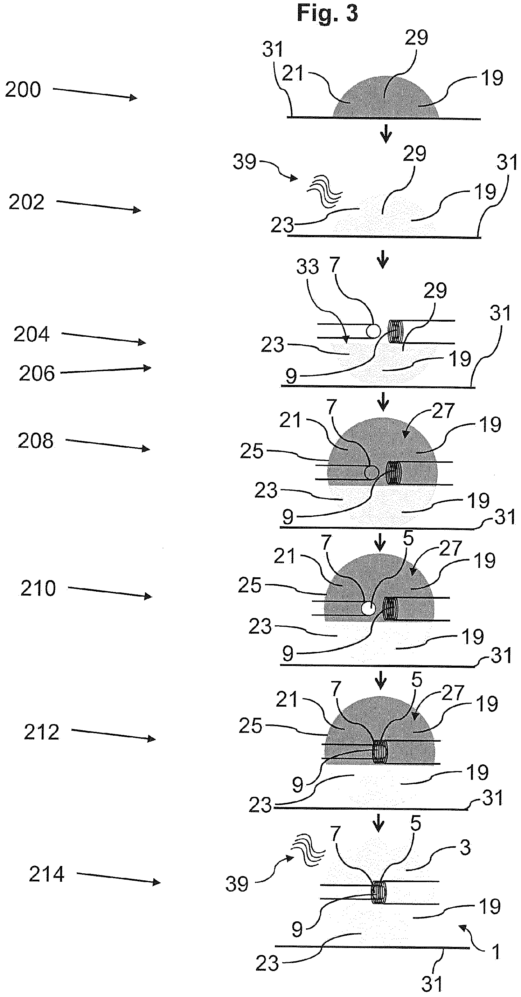

In einem nächsten Verfahrensschritt 106 wird die erste Spule 7 zusammen mit der MR-aktiven Substanz 5 in die zweite Spule 9 hineingeschoben, sodass die Wicklung 13 der Spule 7 von der Wicklung 15 der zweiten Spule 9 umschlossen ist. Die zweite Spule 7 kann beispielsweise einen Innendurchmesser von 1,8mm und einen Außendurchmesser von 2,2mm haben. Die beiden Spulen 7, 9 sind in dem hier beschriebenen Ausführungsbeispiel aus Kupferlackdraht gewickelt. Die Wicklung 13 der ersten Spule 7 und die Wicklung 15 der zweiten Spule 9 umschließen nach diesem Verfahrensschritt beide das von der MR-aktiven Substanz 5 ausgefüllte Volumen 17. Hierbei werden die erste Spule 7, die zweite Spule 9 und die MR-aktive Substanz 5 so verschoben, dass sie genau in der Mitte des Materials 19 angeordnet sind. Zu diesem Zeitpunkt ist das Material 19 noch nicht ausgehärtet. Vor Aushärtung des Materials 19 erhält in Figur 2 wie auch in Figur 3 das Material 19 zusätzlich die Bezugsziffer 21 und ist im dunklen Grauton dargestellt.

In einem abschließenden Herstellungsschritt 108 wird sodann das nicht ausgehärtete Material 19, 21 mit UV-Licht bestrahlt, sodass das Material 19 aushärtet. Nach Aushärtung erhält das Material 19 zusätzlich in Figur 2 wie auch in Figur 3 die Bezugsziffer 23 und ist im hellen Grauton dargestellt.

In Figur 3 ist ein alternatives erfindungsgemäßes Herstellungsverfahren für die Magnetfeldsonde 1 aus Figur 1 illustriert.

In einem ersten Verfahrensschritt 200 wird ein Tropfen eines noch nicht ausgehärteten Materials 19, 21 auf eine ebene Arbeitsfläche 31 aufgetragen. Das Material 19, 21 wird sodann mit UV-Licht 39 bestrahlt, sodass das Material 19 aushärtet und ein ausgehärtetes Material 19, 23 bildet. Dies erfolgt in Schritt 202. Hierdurch entsteht ein Teil einer Kapsel 3.

Im nächsten Verfahrensschritt 204 wird das ausgehärtete Material 19, 23 auf der Arbeitsfläche 31 umgedreht, sodass die Fläche des Materials 19, 23, welches zunächst in Kontakt mit der ebenen Arbeitsfläche 31 stand, eine Unterlage 33 bildet, die eben ist. Auf dieser Unterlage 33 werden sodann die weiteren Verfahrensschritte 206 bis 214 ausgeführt, mit denen die Magnetfeldsonde 1 hergestellt wird. Die Verfahrensschritte 206 bis 214 entsprechen dabei den bereits in Figur 2 zuvor beschriebenen Verfahrensschritten 100 bis 108, wobei die Positionierung der ersten Spule 7 und der zweiten Spule 9 in der Mitte des Materials 19 erleichtert ist, da ein Teil der Kapsel 3 bereits ausgehärtet ist und die erste Spule 7 die zweite Spule 9 daher unmittelbar auf der Unterlage 33 positioniert werden können. Weiteres noch nicht ausgehärtetes Material 19, 21 wird dabei so auf der Unterlage 33 und sodann in mehreren, in Figur 3 nicht explizit dargestellten Schichten, die nach jedem Auftragen Schicht für Schicht ausgehärtet werden, aufgetragen, so dass sich insgesamt eine kugelförmige Kapsel 3 ergibt. Die Unterlage 33 bildet einen Teil der Kapsel 3.

Zusammenfassend wird eine Magnetfeldsonde 1 beschrieben mit einer Kapsel 3, in der eine MR-aktive Substanz 5 eingekapselt ist. Es wird insbesondere vorgeschlagen, dass zwei Spulen 7, 9 in der Kapsel 3 angeordnet werden. Es werden ferner vorteilhafte Herstellungsverfahren für Magnetfeldsonden 1 beschrieben und nützliche Verwendungen der erfindungsgemäßen Magnetfeldsonde 1 sowie Verfahren, bei denen derartige Magnetfeldsonden 1 und Anordnungen von Magnetfeldsonden 1 verwendet werden.

### Bezugszeichenliste

- 1: Magnetfeldsonde
- 3: Kapsel
- 5: MR-aktive Substanz
- 7: erste Spule
- 9: zweite Spule
- 11: Hohlraum
- 13: Wicklung von 7
- 15: Wicklung von 9
- 17: Volumen
- 19: Material
- 21: Material 19 vor Aushärtung
- 23: Material 19 nach Aushärtung
- 25: Oberfläche
- 27: Innenvolumen
- 29: Quantum von 19
- 31: Arbeitsfläche
- 33: Unterlage
- 35: Anschluss
- 37: Anschluss
- 39: UV-Licht
- 41: Pipette

## Patentansprüche

1. System aus einer Magnetfeldsonde (1) und einer Ansteuerungselektronik, wobei die Magnetfeldsonde (1) eine Kapsel (3) umfasst, in der eine MR-aktive Substanz (5) eingekapselt und eine erste Spule (7) angeordnet ist, **dadurch gekennzeichnet, dass** in der Kapsel (3) eine zweite Spule (9) angeordnet ist, dass die zweite Spule (9) an die Ansteuerungselektronik angeschlossen ist und dass die Ansteuerungselektronik zur Erzeugung eines zeitlich konstanten und/oder eines niederfrequenten Magnetfelds eingerichtet ist.

2. System nach dem vorangehenden Anspruch, **dadurch gekennzeichnet, dass** die Kapsel (3) kugelförmig ausgebildet ist und/oder dass die Kapsel (3) aus einem Material (19) gleichmäßiger Zusammensetzung gebildet ist.

3. System nach einem der vorangehenden Ansprüche, **dadurch gekennzeichnet, dass** eine Wicklung (13) der ersten Spule (7) innerhalb einer Wicklung (15) der zweiten Spule (9) angeordnet ist, insbesondere wobei die Wicklungen (13, 15) der ersten Spule (7) und der zweiten Spule (9) und/oder die von der ersten Spule (7) und der zweiten Spule (9) erzeugten Magnetfelder orthogonal zueinander orientiert sind.

4. System nach einem der vorangehenden Ansprüche, **dadurch gekennzeichnet, dass** die zweite Spule (9) derart ausgebildet ist, dass mit ihr in einem von der MR-aktiven Substanz (5) gebildeten Volumen (17) ein homogenes Magnetfeld erzeugbar ist.

5. System nach einem der vorangehenden Ansprüche, **dadurch gekennzeichnet, dass** die zweite Spule (9) derart ausgebildet ist, dass mit ihr in einem von der MR-aktiven Substanz (5) gebildeten Volumen (17) ein räumlich vorzugsweise linear variierendes Magnetfeld erzeugbar ist.

6. System nach einem der vorangehenden Ansprüche, **dadurch gekennzeichnet, dass** die MR-aktive Substanz (5) einen von der Kapsel (3) gebildeten Hohlraum (11) ausfüllt.

7. System nach dem vorangehenden Anspruch, **dadurch gekennzeichnet, dass** die MR-aktive Substanz die Kapsel unmittelbar kontaktiert.

8. System aus einer Anordnung von Magnetfeldsonden (1), einer Empfangselektronik und einer Ansteuerungselektronik, wobei die Magnetfeldsonden (1) jeweils eine Kapsel (3) umfassen, in der eine MR-aktive Substanz (5) eingekapselt und eine erste Spule (7) sowie eine zweite Spule (9) angeordnet ist, wobei die erste Spule (7) an die Empfangselektronik angeschlossen ist, welche zum Empfang eines von der MR-aktiven Substanz (5) ausgesendeten Signals eingerichtet ist und wobei die zweite Spule (9) an die Ansteuerungselektronik angeschlossen ist, welche zur Erzeugung eines zeitlich konstanten und/oder eines niederfrequenten Magnetfeldes eingerichtet ist.

9. Herstellungsverfahren zur Herstellung einer Magnetfeldsonde (1), wobei eine erste Spule (7) in einem aushärtbaren Material (19) angeordnet wird und sodann das aushärtbare Material (19) ausgehärtet wird, **dadurch gekennzeichnet, dass** vor der Aushärtung des Materials eine zweite Spule in dem Material angeordnet wird und dass vor der Aushärtung des (19) Materials (19) eine MR-aktive Substanz (5) in das Material (19) eingebracht, insbesondere injiziert, wird, sodass die MR-aktive Substanz (5) das aushärtbare Material (19) unmittelbar kontaktiert.

10. Herstellungsverfahren zur Herstellung einer Magnetfeldsonde (1) nach dem vorangehenden Anspruch, wobei in ein von einer außenliegenden Oberfläche (25) des aushärtbaren Materials (19) umschlossenes Innenvolumen (27) die MR-aktive Substanz (5) eingebracht wird und das Material (19) sodann ausgehärtet wird und wobei vor der Aushärtung des Materials (19) die erste Spule (7) in dem Innenvolumen (27) angeordnet wird..

11. Herstellungsverfahren nach einem der Ansprüche 9 oder 10, **dadurch gekennzeichnet, dass** das Material (19) mittels elektromagnetischer Strahlung und/oder durch eine Temperaturvariation und/oder katalytisch ausgehärtet wird und/oder dass die Materialeigenschaften der MR-aktiven Substanz (5) und des aushärtbaren Materials (19) so gewählt werden, dass die MR-aktive Substanz (5) nach dem Einbringen in das Material (19) eine elliptische, vorzugsweise kugelförmige Geometrie annimmt.

12. Herstellungsverfahren nach einem der Ansprüche 9 bis 11, **dadurch gekennzeichnet, dass** zunächst ein Quantum (29) des aushärtbaren Materials (19) auf einer vorzugsweise ebenen Arbeitsfläche (31) hergerichtet und ausgehärtet wird und dass sodann das ausgehärtete Quantum (29) umgedreht wird, welches sodann als Unterlage (33) für die weitere Herstellung der Magnetfeldsonde (1) dient.

13. Verfahren zum Betrieb eines Systems aus einer Magnetfeldsonde (1) und einer Ansteuerungselektronik, **dadurch gekennzeichnet, dass** das System gemäß einem der Ansprüche 1 bis 7 ausgebildet ist, wobei mittels der ersten Spule (7) ein Signal der MR-aktiven Substanz (5) empfangen wird und wobei mittels der zweiten Spule (9) ein zeitlich konstantes Magnetfeld oder ein niederfrequentes Magnetfeld erzeugt wird.

14. Verwendung der zweiten Spule (9) einer Magnetfeldsonde (1) eines Systems gemäß einem der Ansprüche 1 bis 7 zur Verschiebung der Resonanzfrequenz der MR-aktiven Substanz (5) während einer MR-Messung eines Messobjekts (21), insbesondere wobei die Resonanzfrequenz soweit verschoben wird, dass das eine Resonanzfrequenz der MR-aktiven Substanz (5) aus der Empfangsbandbreite und/oder Sendebandbreite eines für die MR-Messung verwendeten MR-Geräts und/oder aus der Messbandbreite eines Messsignal, welches von dem Messobjekt bei der MR-Messung erzeugt wird, und/oder aus der Sendebandbreite eines für die MR-Messung verwendeten Anregungsimpulses herausfällt.

## Claims

1. System comprising a magnetic field probe (1) and control electronics, wherein the magnetic field probe (1) comprises a capsule (3) in which an MR-active substance (5) is encapsulated and a first coil (7) is arranged, **characterized in that** a second coil (9) is arranged in the capsule (3), **in that** the second coil (9) is connected to the control electronics, and **in that** the control electronics are designed to generate a temporally constant and/or low-frequency magnetic field.

2. System according to the preceding claim, **characterized in that** the capsule (3) is spherical in shape and/or **in that** the capsule (3) is made of a material (19) of uniform composition.

3. System according to one of the preceding claims, **characterized in that** a winding (13) of the first coil (7) is arranged within a winding (15) of the second coil (9), in particular wherein the windings (13, 15) of the first coil (7) and the second coil (9) and/or the magnetic fields generated by the first coil (7) and the second coil (9) are oriented orthogonally to each other.

4. System according to one of the preceding claims, **characterized in that** the second coil (9) is designed in such a way that a homogeneous magnetic field can be generated with it in a volume (17) formed by the MR-active substance (5).

5. System according to one of the preceding claims, **characterized in that** the second coil (9) is designed such that a spatially preferably linearly varying magnetic field can be generated with it in a volume (17) formed by the MR-active substance (5).

6. System according to one of the preceding claims, **characterized in that** the MR-active substance (5) fills a cavity (11) formed by the capsule (3).

7. System according to the preceding claim, **characterized in that** the MR-active substance is in direct contact with the capsule.

8. System consisting of an arrangement of magnetic field probes (1), receiving electronics, and control electronics, wherein the magnetic field probes (1) each comprise a capsule (3) in which an MR-active substance (5) is encapsulated and a first coil (7) and a second coil (9) are arranged, wherein the first coil (7) is connected to the receiving electronics, which are designed to receive a signal emitted by the MR-active substance (5), and wherein the second coil (9) is connected to the control electronics, which are designed to generate a temporally constant and/or low-frequency magnetic field.

9. Manufacturing method for manufacturing a magnetic field probe (1), wherein a first coil (7) is arranged in a curable material (19) and then the curable material (19) is cured, **characterized in that**, prior to curing the material, a second coil is placed in the material and **in that**, prior to curing the material (19), an MR-active substance (5) is introduced, in particular injected, into the material (19) so that the MR-active substance (5) is in direct contact with the curable material (19).

10. Manufacturing method for manufacturing a magnetic field probe (1) according to the preceding claim, wherein the MR-active substance (5) is introduced into an internal volume (27) enclosed by an outer surface (25) of the curable material (19) and the material (19) is then cured, and wherein, prior to curing the material (19), the first coil (7) is arranged in the internal volume (27).

11. Manufacturing method according to one of claims 9 or 10, **characterized in that** the material (19) is cured by means of electromagnetic radiation and/or by a temperature variation and/or catalytically and/or **in that** the material properties of the MR-active substance (5) and the curable material (19) are selected such that the MR-active substance (5) assumes an elliptical, preferably spherical geometry after being introduced into the material (19).

12. Manufacturing method according to one of claims 9 to 11, **characterized in that** first a quantity (29) of the curable material (19) is prepared and cured on a preferably flat work surface (31) and **in that** the cured quantity (29) is then turned over, which then serves as a base (33) for the further manufacture of the magnetic field probe (1).

13. Method for operating a system consisting of a magnetic field probe (1) and control electronics, **characterized in that** the system is designed according to one of claims 1 to 7, wherein a signal from the MR-active substance (5) is received by means of the first coil (7) and wherein a time-constant magnetic field or a low-frequency magnetic field is generated by means of the second coil (9).

14. Use of the second coil (9) of a magnetic field probe (1) of a system according to one of claims 1 to 7 to shift the resonance frequency of the MR-active substance (5) during an MR measurement of a measurement object (21), in particular wherein the resonance frequency is shifted to such an extent that the resonance frequency of the MR-active substance (5) falls outside the reception bandwidth and/or transmission bandwidth of an MR device used for the MR measurement and/or outside the measurement bandwidth of a measurement signal generated by the measurement object during the MR measurement and/or outside the transmission bandwidth of an excitation pulse used for the MR measurement.

## Revendications

1. Système composé d'une sonde de champ magnétique (1) et d'une électronique d'activation, dans lequel la sonde de champ magnétique (1) comprend une capsule (3) dans laquelle est contenue une substance ayant une activité de RM (5) et une première bobine (7), **caractérisé en ce qu'**une deuxième bobine (9) est disposée dans la capsule (3), **en ce que** la deuxième bobine (9) est connectée à l'électronique d'activation et **en ce que** l'électronique d'activation est agencée de façon à produire un champ magnétique constant dans le temps et/ou à basse fréquence.

2. Système selon la revendication précédente, **caractérisé en ce que** la capsule (3) est sphérique et/ou **en ce que** la capsule (3) est faite d'un matériau (19) de composition uniforme.

3. Système selon l'une des revendications précédentes, **caractérisé en ce qu'**un enroulement (13) de la première bobine (7) est disposé à l'intérieur d'un enroulement (15) de la deuxième bobine (9), les enroulements (13, 15) de la première bobine (7) et de la deuxième bobine (9) et/ou les champs magnétiques produits par la première bobine (7) et la deuxième bobine (9) étant en particulier orientés perpendiculairement l'un à l'autre.

4. Système selon l'une des revendications précédentes, **caractérisé en ce que** la deuxième bobine (9) est conformée de telle manière qu'un champ magnétique homogène puisse être produit avec elle dans un volume (17) formé par la substance ayant une activité de RM (5).

5. Système selon l'une des revendications précédentes, **caractérisé en ce que** la deuxième bobine (9) est conformée de telle manière qu'un champ magnétique variable dans l'espace, de préférence de façon linéaire, peut être produit avec elle dans un volume (17) formé par la substance ayant une activité de RM (5).

6. Système selon l'une des revendications précédentes, **caractérisé en ce que** la substance ayant une activité de RM (5) remplit une cavité (11) formée par la capsule (3).

7. Système selon la revendication précédente, **caractérisé en ce que** la substance ayant une activité de RM est en contact direct avec la capsule.

8. Système formé par une disposition de sondes de champ magnétique (1), une électronique de réception et une électronique d'activation, dans lequel les sondes de champ magnétique (1) comportent chacune une capsule (3) contenant une substance ayant une activité de RM (5) et dans laquelle une première bobine (7) ainsi qu'une deuxième bobine (9) sont disposées, dans lequel la première bobine (7) est connectée à l'électronique de réception qui est agencée pour recevoir un signal émis par la substance ayant une activité de RM (5) et dans lequel la deuxième bobine (9) est connectée à l'électronique d'activation qui est agencée pour produire un champ magnétique constant dans le temps et/ou à basse fréquence.

9. Procédé de fabrication pour la fabrication d'une sonde de champ magnétique (1), dans lequel une première bobine (7) est disposée dans un matériau durcissable (19) et le matériau durcissable (19) est ensuite durci, **caractérisé en ce que**, avant le durcissement du matériau, une deuxième bobine est disposée dans le matériau et **en ce que**, avant le durcissement du matériau (19), une substance ayant une activité de RM (5) est introduite dans le matériau (19) en particulier injectée, de sorte que la substance ayant une activité de RM (5) vient en contact direct avec le matériau durcissable (19).

10. Procédé de fabrication pour la fabrication d'une sonde de champ magnétique (1) selon la revendication précédente, dans lequel la substance ayant une activité de RM (5) est introduite dans un volume intérieur (27) renfermé par une surface extérieure (25) du matériau durcissable (19) et le matériau (19) est ensuite durci et dans lequel, avant le durcissement du matériau (19), la première bobine (7) est disposée dans le volume intérieur (27).

11. Procédé de fabrication selon l'une des revendications 9 ou 10, **caractérisé en ce que** le matériau (19) est durci au moyen d'un rayonnement électromagnétique et/ou par une variation de température et/ou par catalyse et/ou **en ce que** les propriétés de matériau de la substance ayant une activité de RM (5) et du matériau durcissable (19) sont choisies de telle sorte que la substance ayant une activité de RM (5) prenne, après introduction dans le matériau (19), une forme elliptique, de préférence sphérique.

12. Procédé de fabrication selon l'une des revendications 9 bis 11, **caractérisé en ce qu'**une quantité (29) du matériau durcissable (19) est d'abord disposée sur une surface de travail (31) de préférence plane et durcie et **en ce que** la quantité (29) durcie est ensuite retournée et sert alors de base (33) pour la suite de la fabrication de la sonde de champ magnétique (1).

13. Procédé de conduite d'un système composé d'une sonde champ magnétique (1) et d'une électronique d'activation, **caractérisé en ce qu'**il est conçu selon l'une des revendications 1 à 7, un signal de la substance ayant une activité de RM (5) étant capté au moyen de la première bobine (7) et un champ magnétique constant dans le temps ou un champ magnétique à basse fréquence étant produit au moyen de la deuxième bobine (9).

14. Utilisation de la deuxième bobine (9) d'une sonde de champ magnétique (1) d'un système selon l'une des revendications 1 à 7 pour décaler la fréquence de résonance de la substance ayant une activité de RM (5) pendant une mesure par RM d'un objet à mesurer (21), en particulier dans laquelle la fréquence de résonance est suffisamment décalée pour qu'une fréquence de résonance de la substance ayant une activité de RM (5) sorte de la bande de réception et/ou de la bande d'émission d'un appareil de RM utilisé pour la mesure par RM et/ou de la bande de mesure d'un signal de mesure qui est produit par l'objet à mesurer lors de la mesure par RM et/ou de la bande d'émission d'une impulsion d'excitation utilisée pour la mesure par RM.
